# EUROPEAN PATENT APPLICATION

(11) **EP 4 718 495 A1**
(43) Date of publication of application: **01.04.2026**
(21) Application number: 25204721.2
(22) Date of filing: 25.09.2025
(51) Int. Cl.: H01J 37/32, G01R 19/00

(54) **VI SENSOR AND METHOD FOR MONITORING PLASMA STATE**

(30) Priority: 27.09.2024 KR 20240131584
(71) Applicant: Korea Institute of Fusion Energy, Daejeon 34133 (KR)
(72) Inventor: KIM, Jongsik, 54138 Jeonbuk-do (KR); PARK, Sanghyeok, 17608 Gyeonggi-do (KR); CHO, Ki Hwan, 34509 Daejeon (KR); SONG, Jung Ho, 30092 Sejong-si (KR)
(74) Representative: Seemann & Partner Patentanwälte mbB

(57) **Abstract**

The present disclosure relates to a VI sensor and a method for monitoring a plasma state, and includes a collector configured to collect, as sensing data, **RF** voltages, **RF** currents, incident wave powers, and reflected wave powers generated during a plasma process, and a processor configured to train an artificial intelligence algorithm by applying the sensing data and setting values of plasma equipment identified at the time when the sensing data is generated, and to derive prediction data capable of monitoring a plasma state and a plasma process state using the trained artificial intelligence algorithm, and other embodiments are also applicable.

## Description

### 1. TECHNICAL FIELD

The present disclosure relates to a voltage-current sensor (hereinafter, referred to as a VI sensor) and method for monitoring plasma state.

### 2. RELATED ART

In general, in the manufacturing process of a semiconductor device, plasma equipment that performs etching and deposition of a semiconductor substrate using plasma generated by highfrequency power is widely used. Various sensors are attached to the plasma equipment, and whether the plasma equipment or accessories are operating and their operation states are determined based on sensing data obtained from the sensors.

Currently, sensing data acquired from sensors attached to the plasma equipment are analyzed to determine a start point and an end point of a plasma process, to determine whether there is an abnormality in functions such as the presence or absence of plasma generation, to determine an end point of wafer etching, and to determine whether process by-products generated inside the plasma equipment are removed. However, since the accuracy thereof is very low, there are frequent cases where the plasma process stops in the middle of the process, is determined to be abnormal even when operating normally, or is determined to be normal even when operating abnormally, resulting in a problem of decreased productivity.

Therefore, there is a need for technology development that can address the problem of decreased productivity by more accurately identifying a plasma state or a plasma process state.

### SUMMARY

Embodiments of the present disclosure for solving the above-described problems provide a VI sensor and a method for monitoring plasma state, in which an artificial intelligence algorithm mounted on the VI sensor is trained with sensing data acquired from the VI sensor attached to plasma equipment, and data related to a plasma state is derived based on a training result to monitor the plasma state.

According to an embodiment of the present disclosure, a VI sensor for monitoring a plasma state includes a collector configured to collect, as sensing data, RF voltages, RF currents, incident wave powers, and reflected wave powers generated during a plasma process, and a processor configured to apply the sensing data and setting values of a plasma equipment identified at the time when the sensing data is generated to an artificial intelligence algorithm to train the artificial intelligence algorithm, and to derive prediction data capable of monitoring a plasma state and a plasma process state using the trained artificial intelligence algorithm.

In addition, the processor is configured to verify the prediction data.

In addition, the processor is configured to determine, based on a verification result of the verification, whether to stop the plasma process or whether it is required to retrain the artificial intelligence algorithm.

In addition, the VI sensor further includes communicator, wherein the communicator is configured to transmit, to an electronic device, the prediction data verified by the processor.

Further, according to an embodiment of the present disclosure, a method for monitoring a plasma state, includes collecting, using a VI sensor, as sensing data, RF voltages, RF currents, incident wave powers, and reflected wave powers generated during a plasma process, training, by the VI sensor, an artificial intelligence algorithm by applying the sensing data and setting values of a plasma equipment identified at the time when the sensing data is generated to the artificial intelligence algorithm, and deriving, using the VI sensor, prediction data capable of monitoring a plasma state and a plasma process state using the trained artificial intelligence algorithm.

In addition, the method further includes verifying, using the VI sensor, the prediction data.

In addition, the method may further include determining, using the VI sensor, whether to stop the plasma process or whether retraining of the artificial intelligence algorithm is required, based on a verification result of the verification.

In addition, the method may further include transmitting, using the VI sensor, a stop request message of the plasma process to an electronic device when it is required to stop the plasma process.

In addition, the method may further include retraining, using the VI sensor, the artificial intelligence algorithm when it is required to retrain the artificial intelligence algorithm.

In addition, the method may further include transmitting, using the VI sensor, the prediction data verified by the verification to an electronic device.

As described above, the VI sensor and method for monitoring plasma state according to the present disclosure have an effect of monitoring a plasma state by training an artificial intelligence algorithm mounted on the VI sensor with sensing data acquired from the VI sensor attached to plasma equipment, and by deriving data related to the plasma state based on a training result.

### BRIEF DESCRIPTION OF THE DRAWINGS

FIG. 1 is a diagram schematically illustrating plasma equipment in which a VI sensor is disposed according to an embodiment of the present disclosure.
FIG. 2 is a diagram illustrating a system including a VI sensor for performing plasma state monitoring according to an embodiment of the present disclosure.
FIG. 3 is a flowchart illustrating a method for monitoring a plasma state in a VI sensor according to an embodiment of the present disclosure.

### DETAILED DESCRIPTION

This invention was made with support from the National Research and Development Program of Korea. The information of the supported project is as follows:
[Assignment Unique Number] 1711203519
[Assignment Number] CRC20014-000
[Name of the Ministry] Korea Ministry of Science and ICT
[Name of the Assignment Managing (Professional) Organization]
National Research Council of Science & Technology (NST)
[Research Project Title] National Research Council of Science & Technology (NST) Research Operation Expense Support (Major Project Expense) - Future-Oriented Convergence Research Program
[Assignment Title] Development and Demonstration of Intelligent Semiconductor Plasma Process Equipment Technology
[Name of the Organization Performing the Assignment] Korea Institute of Fusion Energy (KFE)
[Research Period] 2020.11.01-2026.10.31

Hereinafter, preferred embodiments of the present disclosure will be described in detail with reference to the accompanying drawings. The detailed description disclosed below together with the accompanying drawings is intended to explain exemplary embodiments of the present disclosure and is not intended to represent the only embodiments in which the present disclosure can be implemented. In the drawings, parts irrelevant to the description may be omitted for clarity of explanation of the present disclosure, and the same reference numerals may be used for the same or similar components throughout the specification.

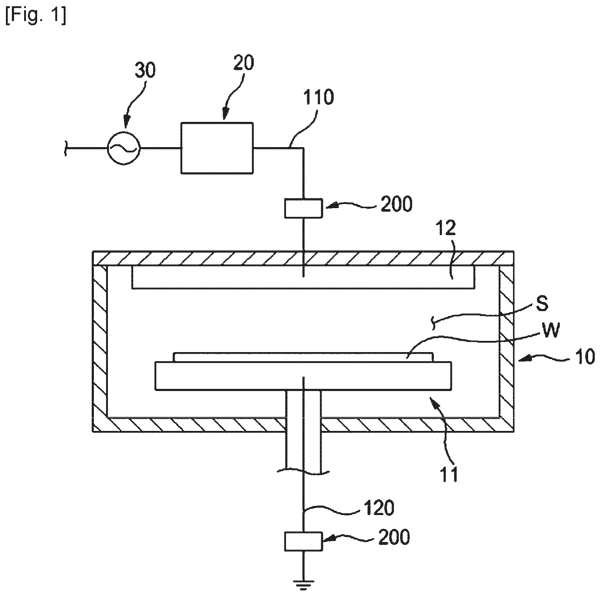

FIG. 1 is a diagram schematically illustrating plasma equipment in which a VI sensor is disposed according to an embodiment of the present disclosure.

Referring to FIG. 1, the plasma equipment may include a process chamber 10 configured to form a sealed processing space S in which plasma is generated for performing substrate processing, a substrate support 11 disposed in the processing space S to hold a substrate W, and a gas injection port 12 configured to inject a gas for performing a process into the processing space S.

The process chamber 10 may be variously configured to form the sealed processing space S in which plasma is generated for processing the substrate.

The substrate support 11 may be variously configured to hold the substrate W by being installed in the processing space S. For example, the substrate support 11 may include a susceptor (not shown) on which the substrate W is seated and a support rod (not shown) extending from a bottom surface of the susceptor to support the susceptor.

The gas injection port 12 may be variously configured to inject the process gas into the processing space S according to a gas injection structure. For example, the gas injection port 12 may include a showerhead (not shown) configured to inject downward a gas supplied through a gas supply pipe (not shown) installed at an upper side.

The plasma equipment is configured such that one or more RF power sources 30 are applied to at least one of the process chamber 10, the substrate support 11, and the gas injection port 12 to perform substrate processing. To this end, one or more RF power sources 30 may be applied to at least one of the process chamber 10, the substrate support 11, and the gas injection port 12, and a matching network 20 may be installed between the RF power source 30 and a power supply line 110. The RF power source 30 may supply one or more RF power sources, such as a high frequency or a low frequency, depending on process conditions.

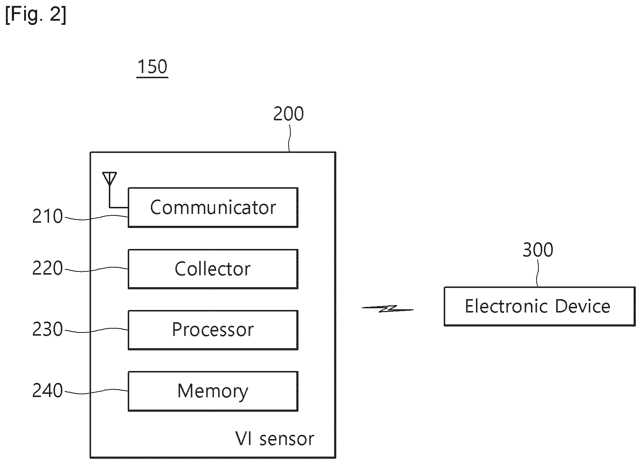

The VI sensor 200 is a VI probe sensor and may be installed adjacent to at least one of a first power supply line 110 for applying RF power 30 and a ground line 120 for grounding to measure, as sensing data, RF voltages, RF currents, incident wave powers, and reflected wave powers generated by plasma in the processing space S. The VI sensor 200 may train an artificial intelligence algorithm using the measured sensing data and may derive prediction data capable of monitoring a plasma state and a plasma process state by using the artificial intelligence algorithm. A more detailed operation of the VI sensor 200 will be described with reference to FIG. 2 below. In addition, although the embodiment of the present disclosure is described as an example in which one VI sensor 200 is provided in the plasma equipment, the number of VI sensors may be changed according to the number of antennas and electrodes provided in the plasma equipment.

FIG. 2 is a diagram illustrating a system including a VI sensor for performing plasma state monitoring according to an embodiment of the present disclosure.

Referring to FIG. 2, the VI sensor 200 according to the present disclosure may include a communicator 210, a collector 220, a processor 230, and a memory 240.

The communicator 210 transmits result data derived from the processor 230 to the electronic device 300 through communication with the electronic device 300 to monitor the plasma state and the plasma process state. To this end, the communicator 210 may use communication methods such as Wireless Fidelity (Wi-Fi), Bluetooth, or Bluetooth Low Energy (BLE) to communicate with the electronic device 300.

The collector 220 collects sensing data generated during the plasma process, including RF voltages, RF currents, incident wave powers, and reflected wave powers, and transmits the sensing data to the processor 230.

The processor 230 performs learning of the artificial intelligence algorithm by applying the collected sensing data and a setting value at the time of acquiring the sensing data to the artificial intelligence algorithm. In this case, the setting value may include a plasma state (for example, electron density and electron temperature) and a plasma process state (for example, a process such as an etching process) at the time of acquiring the sensing data.

The processor 230 may adjust the number of training iterations, the sensing data load size, the number of layers, and the like to improve training accuracy. In addition, the processor 230 may provide a function of searching for a setting value that derives the best result value by repeatedly inputting a setting value within a predetermined range. In this case, the setting value within the predetermined range may refer to a value set through a GridSearchCV technique for searching for a training condition capable of most accurately predicting a result value.

The processor 230 may input test data into the artificial intelligence algorithm to check prediction accuracy and prediction time and may use only training results that satisfy the accuracy and response time set by the user of the VI sensor 200. In this case, the processor 230 may set one or more training results corresponding to the accuracy and response time set by the user. Through this, the processor 230 may continuously log the prediction values generated while training is repeated and may select the artificial intelligence algorithm having the highest accuracy. The processor 230 stores the trained artificial intelligence algorithm in the memory 240.

The processor 230 may apply sensing data collected from the VI sensor 200 to the trained artificial intelligence algorithm to generate prediction data for a plasma state and a plasma process state. In this case, the sensing data applied to the artificial intelligence algorithm may be sensing data collected after the training of the artificial intelligence algorithm is completed. In addition, the prediction data may include the sensing data applied to the artificial intelligence algorithm, the prediction time, the artificial intelligence algorithm used for prediction, the prediction results (the plasma state and the plasma process state), and actual measurement values.

The processor 230 may perform verification of prediction data by comparing the prediction data predicted by the processor 230 with actual measurement results obtained in a testing process performed after the actual plasma process is completed. In this case, the processor 230 may compare the prediction data with the actual measurement results periodically or in real time.

When an error between the prediction data and the actual measurement results exceeds an allowable error range included in preset verification information by at least a threshold number of times, the processor 230 may determine that stopping the plasma process is required, and may transmit a message indicating the need to stop the plasma process to the electronic device 300.

When an error between the prediction data and the actual measurement results exceeds an allowable error range included in preset verification information by at least a threshold number of times, the processor 230 may determine that retraining of the artificial intelligence algorithm is required. In this case, a criterion for determining whether to stop the plasma process and a criterion for determining whether retraining of the artificial intelligence algorithm is required may be different. When the processor 230 determines that retraining of the artificial intelligence algorithm is required, the processor 230 performs the retraining of the artificial intelligence algorithm.

In addition, when retraining of the artificial intelligence algorithm is not required or when retraining is completed, the processor 230 applies sensing data to the trained artificial intelligence algorithm stored in the VI sensor 200 and transmits prediction data for the plasma state and the plasma process state to the electronic device 300. Accordingly, the electronic device 300 may monitor the plasma state and the plasma process state predicted by the VI sensor 200.

The memory 240 stores operation programs for operating the VI sensor 200. More specifically, the memory 240 may store an artificial intelligence algorithm trained by the processor 230.

The electronic device 300 is a device capable of controlling plasma equipment (not shown) through communication with plasma equipment, and may be an electronic device such as a computer, a notebook computer, or a tablet PC. The electronic device 300 displays prediction data received from the VI sensor 200 so that a user can check the plasma state and the plasma process state. In addition, the electronic device 300 controls the operation of the plasma equipment based on the prediction data received from the VI sensor 200.

More specifically, the electronic device 300 may plan parameter values to be controlled during a process in the plasma equipment based on the prediction data received from the VI sensor 200. When a plasma state value identified based on the prediction data differs from a preset range by at least a threshold, the electronic device 300 may receive, from a user, information on a change item, a change amount, a process parameter, a number of processes, a process execution time, and the like, in which the plasma state has changed.

When a plasma process state identified based on the prediction data differs from a range of a preset process state by at least a threshold, the electronic device 300 may receive, from a user, a process influence related to a change item in which the plasma state has changed.

The electronic device 300 may generate a control combination based on a control factor adjustable under a parameter control combination condition including information on an item that may be adjusted in at least one process among a process in which an identified predicted plasma state value deviates from a range of a preset plasma state value by at least a threshold and a process in which an identified plasma process state deviates from a range of a preset process state by at least a threshold.

The process control combination may perform training by applying sensing data obtained from the performed process, a plasma state value and a plasma process state predicted corresponding to the sensing data, to a reinforcement learning algorithm, which is an artificial intelligence algorithm.

When prediction of the process control combination is completed using the reinforcement learning algorithm, the electronic device 300 performs a process influence evaluation on the predicted control combination. The process influence evaluation may determine whether the control combination is within a range defined by a preset parameter control constraint, and when the control combination is within the preset range, may store a parameter control recommendation combination and control information of parameter adjustment amounts as data for more stably controlling the plasma equipment.

The electronic device 300 may control parameter values for the plasma equipment based on the set process control combination.

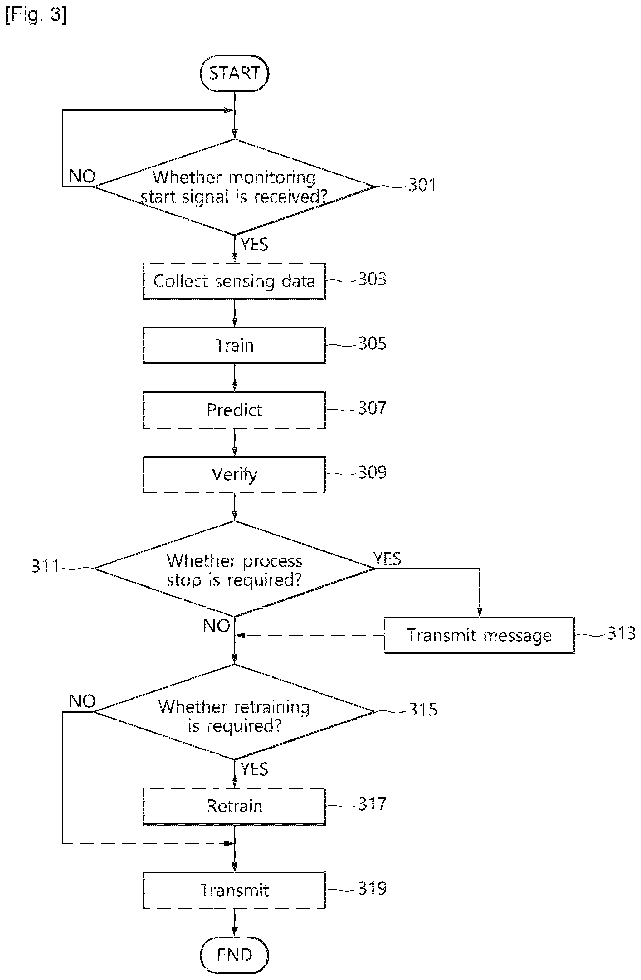

FIG. 3 is a flowchart illustrating a method for monitoring a plasma state in a VI sensor according to an embodiment of the present disclosure.

Referring to FIG. 3, in operation S301, the processor 230 performs operation S303 when a start signal for monitoring a plasma state and a plasma process state of the plasma equipment is received and waits to receive the start signal when the start signal is not received. In this case, the start signal may be an activation signal of the VI sensor 200 received from the electronic device 300 through the communicator 210.

In operation S303, the collector 220 collects sensing data. In this case, the sensing data may include RF voltages, RF currents, incident wave powers, and reflected wave powers generated during the plasma process.

In operation S305, the processor 230 performs training of the artificial intelligence algorithm by applying the collected sensing data and a set value at the time of acquiring the sensing data to the artificial intelligence algorithm. In this case, the setting value may include a plasma state (for example, electron density and electron temperature) and a plasma process state (for example, a process such as an etching process) at the time of acquiring the sensing data.

The processor 230 may adjust the number of training iterations, the sensing data load size, the number of layers, and the like to improve training accuracy. In addition, the processor 230 may provide a function of searching for a setting value that derives the best result value by repeatedly inputting a setting value within a predetermined range. In this case, the setting value within the predetermined range may refer to a value set through a GridSearchCV technique for searching for a training condition capable of most accurately predicting a result value.

The processor 230 may input test data into the artificial intelligence algorithm to check prediction accuracy and the time required for prediction and may use only training results that satisfy the accuracy and response time set by the user of the VI sensor 200. In this case, the processor 230 may set one or more training results corresponding to the accuracy and response time set by the user. Through this, the processor 230 may continuously log prediction values generated while training is repeated and may select the artificial intelligence algorithm having the highest accuracy. The processor 230 stores the trained artificial intelligence algorithm in the memory 240.

In operation S307, the processor 230 applies sensing data collected from the VI sensor 200 to the trained artificial intelligence algorithm to generate prediction data for a plasma state and a plasma process state. In this case, the sensing data applied to the artificial intelligence algorithm may be sensing data collected after training of the artificial intelligence algorithm is completed. In addition, the prediction data may include the sensing data applied to the artificial intelligence algorithm, the prediction time, the artificial intelligence algorithm used for prediction, the prediction results (the plasma state and the plasma process state), and actual measurement values.

In operation S309, the processor 230 performs verification of prediction data by comparing the prediction data predicted by the processor 230 with actual measurement results obtained in a testing process performed after the actual plasma process is completed. In this case, the processor 230 may compare the prediction data with the actual measurement results periodically or in real time.

In operation S311, the processor 230 performs operation S315 when it is determined from a verification result that stopping of the plasma process is required and performs operation S315 when stopping of the plasma process is not required. More specifically, the processor 230 may determine that stopping of the plasma process is required when an error between the prediction data and the actual measurement results exceeds an allowable error range included in preset verification information by at least a threshold number of times.

In operation S313, the processor 230 may generate a message indicating that stopping of the plasma process is required and may transmit the message to the electronic device 300.

On the contrary, in operation S315, the processor 230 checks whether retraining of the artificial intelligence algorithm is required. More specifically, the processor 230 may determine that retraining of the artificial intelligence algorithm is required when an error between the prediction data and the actual measurement results exceeds an allowable error range included in preset verification information by at least a threshold number of times. In this case, a criterion for determining whether to stop the plasma process and a criterion for determining whether retraining of the artificial intelligence algorithm is required may be different.

As a result of the check in operation S315, when it is determined that retraining of the artificial intelligence algorithm is required, the processor 230 performs operation S317, and when it is determined that retraining is not required, the processor 230 performs operation S319. In operation S317, the processor 230 performs retraining of the artificial intelligence algorithm.

On the contrary, in operation S319, when retraining of the artificial intelligence algorithm is not required or when retraining is completed, the processor 230 transmits to the electronic device 300 prediction data for the plasma state and the plasma process state generated by applying sensing data to the trained artificial intelligence algorithm of the VI sensor 200. Accordingly, the electronic device 300 may monitor the plasma state and the plasma process state predicted by the VI sensor 200.

The embodiments of the present disclosure disclosed in the specification and the drawings are merely provided as specific examples to easily describe the technical content of the present disclosure and to help understand the present disclosure, and are not intended to limit the scope of the present disclosure. Accordingly, the scope of the present disclosure should be interpreted as including all changes or modified forms derived based on the technical idea of the present disclosure in addition to the embodiments disclosed herein.

## Claims

1. A Voltage-Current (VI) sensor for monitoring a plasma state, comprising:
a collector configured to collect, as sensing data, RF voltages, RF currents, incident wave powers, and reflected wave powers generated during a plasma process; and
a processor configured to apply the sensing data and setting values of a plasma equipment identified at the time when the sensing data is generated to an artificial intelligence algorithm to train the artificial intelligence algorithm, and to derive prediction data capable of monitoring a plasma state and a plasma process state using the trained artificial intelligence algorithm.

2. The VI sensor of claim 1, wherein the processor is configured to verify the prediction data.

3. The VI sensor of claim 2, wherein the processor is configured to determine, based on a verification result of the verification, whether to stop the plasma process or whether it is required to retrain the artificial intelligence algorithm.

4. The VI sensor of claim 3, further comprising: a communicator,
wherein the communicator is configured to transmit, to an electronic device, the prediction data verified by the processor.

5. A method for monitoring a plasma state, comprising:
collecting, using a VI sensor, as sensing data, RF voltages, RF currents, incident wave powers, and reflected wave powers generated during a plasma process;
training, by the VI sensor, an artificial intelligence algorithm by applying the sensing data and setting values of a plasma equipment identified at the time when the sensing data is generated to the artificial intelligence algorithm; and
deriving, using the VI sensor, prediction data capable of monitoring a plasma state and a plasma process state using the trained artificial intelligence algorithm.

6. The method of claim 5, further comprising:
verifying, using the VI sensor, the prediction data.

7. The method of claim 6, further comprising:
determining, using the VI sensor, whether to stop the plasma process or whether retraining of the artificial intelligence algorithm is required, based on a verification result of the verification.

8. The method of claim 7, further comprising:
transmitting, using the VI sensor, a stop request message of the plasma process to an electronic device when it is required to stop the plasma process.

9. The method of claim 7, further comprising:
retraining, using the VI sensor, the artificial intelligence algorithm when it is required to retrain the artificial intelligence algorithm.

10. The method of claim 7, further comprising:
transmitting, using the VI sensor, the prediction data verified by the verification to an electronic device.
